# EUROPEAN PATENT APPLICATION

(11) **EP 2 458 396 A1**
(43) Date of publication of application: **30.05.2012**
(21) Application number: 11190387.8
(22) Date of filing: 23.11.2011
(51) Int. Cl.: G01R 33/36, H01Q 15/00

(54) **Magnetic imaging with a metameterial lens**

(30) Priority: 24.11.2010 US 926560
(71) Applicant: Lockheed Martin Corporation, Bethesda, MD 20817 (US)
(72) Inventor: Drake, Christina, Oviedo, FL Florida 32765 (US); Rivero-Baleine, Clara, Orlando, FL Florida 32822 (US)
(74) Representative: Fredriksson, Teresia

(57) **Abstract**

Methods and apparatuses of the present invention perform imaging using a metamaterial lens structure. The apparatus according to one embodiment comprises: a field source (21) capable of generating an electromagnetic field directed to an area in an object or target (31); a field detector (41) arranged downstream from the field source, the field detector being capable of detecting a field signature associated with the area in the object or target; and a metamaterial lens structure (91A) arranged downstream from the field source, the metamaterial lens structure concentrating the electromagnetic field produced by the field source to the area in the object or target, or concentrating the field signature from the area in the object or target to the field detector.

## Description

### CROSS REFERENCE TO RELATED APPLICATIONS

This European application claims priority to U.S. Application No. 12/926,560 filed November 24, 2010 which is a continuation in part under U.S.C. § 120 of U.S. Application No. 12/801,799 filed on June 25, 2010, which claims priority under 35 U.S.C. § 119(e) to U.S. Provisional Application No. 61/213,624 filed on June 25, 2009, the entire contents of these applications being hereby incorporated by reference.

### BACKGROUND OF THE INVENTION

### 1. Field of the Invention

The present invention relates to an imaging technique and imaging apparatus, and more particularly to a method and apparatus for direct magnetic imaging.

### 2. Description of the Related Art

Magnetic resonance imaging (MRI) is a technique which uses magnetic fields and RF waves to obtain pictures of structures inside the body. With this technique, a strong magnetic field is used to align the protons in a subject. Radio frequency (RF) waves are then transmitted into the subject at the proton's Larmor frequency, causing a transient magnetic field. When the RF signal is turned off the protons relax, emitting an RF signal in the process. The RF waves which are re-transmitted by protons are received by MRI RF coils. In order to produce an MRI image, the RF signal needs to be encoded for each dimension; otherwise, spatial information cannot be obtained. The information is encoded by adding a gradient to the static magnetic field that surrounds the subject, by using gradient coils, for example. Fourier Transform is used to retrieve an image from the collected signal, by transforming the encoded image to spatial domain to create a 3D picture.

In the conventional MRI process no real magnetic image is obtained. As explained above, MRI requires sophisticated software analysis involving RF signal encoding and Fourier Transform to re-construct an image. These difficulties are due to the MRI process specifications which are set in connection with the Larmor frequency of the proton. For a 1.5 Tesla MRI machine, for example, the proton's Larmor frequency (for hydrogen atoms) is approximately 64 MHz, which corresponds to a wavelength of ∼4.7 meters, which is in the RF range of the electromagnetic spectrum. This wavelength is quite long and cannot individually resolve small anatomical features, such as features of organs and tissues, cancer formations, etc., that need to be imaged. In order to obtain a reasonable resolution with MRI, the gradient coils are used to encode a signal from the subject in each dimension, and Fourier Transform is used to retrieve an image from the collected signal. Without encoding, spatial information is not obtainable through traditional MRI, and, even with encoding, the magnetic image can be reconstructed only by sophisticated software analysis which is time consuming and computationally intensive.

Traditional clinical MRI systems are also quite large and heavy because of the cryogenic cooling and magnetic shielding requirements. State-of-the-art portable MRI versions suffer from a lack of sensitivity and poor image quality. Traditional portable MRI systems have reduced sensitivity due to the fact that they operate at lower magnetic fields than what would be found in a hospital setting (typically in the 0.2-0.5T range). The MRI signal is usually proportional to the magnetic field applied to the subject, so that lower field MRI devices have poorer signal to noise ratio. Furthermore, the quality of the gradient field which probes the patient for spatial information is affected by every inhomogeneity in the permanent magnetic field. Therefore, these portable MRI machines are typically used for extremity imaging only (e.g. knee, elbow, etc), not for whole body imaging.

Disclosed embodiments of this application address these and other issues by providing imagers and methods for direct imaging, including, but not limited to, direct magnetic imaging. A Direct Magnetic Imager of the present invention includes one or more metamaterial lenses which focus a magnetic field down into an object or target and may also collect the signal back to a receiver. The Direct Magnetic Imager facilitates imaging in MRI and NMR applications, improving signal to noise ratio, resolution and sensitivity while decreasing acquisition time, device size and shielding requirements as compared with traditional imaging systems. The metamaterial lens(es) may replace gradient coils used in traditional MRI units to encode the RF signal in each spatial dimension, allowing focusing of the RF fields for direct imaging applications. The metamaterial lens(es) may also be added to state-of-the art imagers to improve sensitivity and detector SNR, without altering the system configuration. The metamaterial lens(es) in the Direct Magnetic Imager may be focused in multiple dimensions and may be tuned to specific frequencies in connection with frequencies detected by the detector/receiver. The Direct Magnetic Imager can be used for imaging, detection and sensing in a variety of fields, including medical, military and security applications.

### SUMMARY OF THE INVENTION

The present invention is directed to imaging methods and apparatuses. According to a first aspect of the present invention, an imager comprises: a field source capable of generating an electromagnetic field directed to an area in an object or target; a field detector arranged downstream from said field source, said field detector being capable of detecting a field signature associated with said area in said object or target; and a metamaterial lens structure arranged downstream from said field source, said metamaterial lens structure concentrating said electromagnetic field produced by said field source to said area in said object or target, or concentrating said field signature from said area in said object or target to said field detector.

In some variations, said metamaterial lens structure includes one or more metamaterial lenses and/or arrays of metamaterial lenses, each of said metamaterial lenses includes multiple unit cells, each unit cell including at least one ring with lumped capacitors and/or inductors, and for each metamaterial lens the magnetic permeability is equal to minus one, or the electric permittivity is equal to minus one, or the refractive index is equal to minus one. In further variations, said metamaterial lens structure is an engineered device with a refractive index equal to minus one, or with a magnetic permeability equal to minus one, or with an electric permittivity equal to minus one.

In some variations, the electromagnetic field includes a magnetic field and said field detector includes a magnetic field detector. In further variations, the electromagnetic field includes an electric field and said field detector detects electric fields. In other variations, said electromagnetic field includes an RF signal, and said metamaterial lens structure performs focusing of said RF signal by encoding said RF signal in multiple spatial dimensions.

In some variations, the metamaterial lens structure is refocused in one or more dimensions. In some variations, said imager performs direct magnetic imaging by which a magnetic field is focused by said metamaterial lens structure into said object/target and/or into said field detector, by refocusing said metamaterial lens structure in one or more dimensions.

In some variations, the electromagnetic field is an AC magnetic field at a frequency characteristic to said object/target, and said metamaterial lens structure focuses said AC magnetic field into said object/target and also focuses said field signature to said field detector. In further variations, there are two (or more) metamaterial lens structures, where one metamaterial lens structure focuses said AC magnetic field into said object/target, and another metamaterial lens structure focuses said field signature to said field detector.

In some variations, the imager is an MRI imager comprising gradient coils, said field detector is an RF receiver, and said metamaterial lens structure concentrates an RF field to a specific area of said object and/or concentrates a magnetic field signature from said specific area to said RF receiver. In further variations, the imager is an MRI or an NMR imager which has been modified to include said metamaterial lens structure.

In other variations, said field detector is a tunable magnetometer, and said metamaterial lens structure is tuned to one or more collecting frequencies of said magnetometer while concentrating a magnetic field signature into said field detector. In other variations, the field detector detects said field signature using one or more of a super quantum interference detector, a magnetometer detector, an antenna, an RF coil, and a MEMS device.

In some variations, the metamaterial lens structure concentrates said field signature from said area in said object/target to said field detector, and said metamaterial lens is tuned to specific frequencies in conjunction with frequencies detected by said field detector.

According to a second aspect of the present invention, an imaging method comprises: generating an electromagnetic field directed to an area in an object or target; detecting a field signature associated with said area in said object or target; and concentrating, using a metamaterial lens structure, said electromagnetic field to said area in said object or target, and/or concentrating said field signature from said area in said object or target before said detecting step.

In some variations, the concentrating step is performed by one or more metamaterial lenses having a magnetic permeability equal to minus one, or an electric permittivity equal to minus one, or a refractive index equal to minus one, and each of said metamaterial lenses includes multiple unit cells, each unit cell including at least one ring with lumped capacitors and/or inductors. In other variations, the concentrating step is performed by one or more metamaterial lenses with a refractive index equal to minus one, or with a magnetic permeability equal to minus one, or with an electric permittivity equal to minus one. In further variations, the concentrating step includes refocusing said metamaterial lens structure in one or more dimensions.

In some variations, the method performs direct magnetic imaging by which a magnetic field is focused by said metamaterial lens structure into said object/target and/or into said field detector, by refocusing said metamaterial lens structure in one or more dimensions.

In some variations, the electromagnetic field is a magnetic field. In other variations, the electromagnetic field is an electric field. In some variations, the electromagnetic field is an RF signal, and said concentrating step comprises focusing said RF signal by said metamaterial lens structure, by encoding said RF signal in multiple spatial dimensions. In other variations, the electromagnetic field is an AC magnetic field at a frequency characteristic to said object/target, and said concentrating step comprises focusing said AC magnetic field by said metamaterial lens structure into said object/target, and focusing said field signature from said object/target, by said metamaterial lens structure, before said detecting step. In further variations, the electromagnetic field is an AC magnetic field at a frequency characteristic to said object or target, and said concentrating step comprises focusing said AC magnetic field by said metamaterial lens structure into said object/target, and focusing said field signature from said object/target, by a second metamaterial lens structure, before said detecting step.

In some variations, the method is a method for magnetic resonance imaging, and said concentrating step concentrates an RF field by said metamaterial lens structure to an anatomical area, and concentrates a magnetic field signature from said anatomical area to an RF receiver by another metamaterial lens structure. In other variations, the method is a method for nuclear magnetic imaging

In some variations, the method further includes tuning said metamaterial lens structure to one or more detecting frequencies used in said detecting step, while concentrating said field signature which is a magnetic field signature. In other variations, said concentrating step and said detecting step comprise tuning at one or more detecting frequencies. In yet other variations, the step of concentrating the field signature further comprises tuning said metamaterial lens structure to one or more detecting frequencies used in said detecting step. In further variations still, the field signature is a magnetic field signature.

According to a third aspect of the present invention, a metamaterial lens comprises multiple unit cells, each unit cell including at least one ring with lumped capacitors and/or inductors. In some variations, each of said unit cells is a parallelepiped including said capacitors and inductors along a plurality of sides of said parallelepiped. In other variations, the lens is an isotropic lens in which said unit cells are arranged in an array.

In some variations, rings in said unit cells include only lumped capacitors. In further variations, at least one ring includes capacitors, and meander line inductors. In other variations, each of said unit cells includes at least one split ring with lumped capacitors and inductors. In further variations, at least one split ring is a split ring resonator element including a metal strip and a gap, wherein said split ring acts as the unit cell and said gap is filled with a capacitor or inductor.

In some variations, the lens includes a magnetic material. In other variations, the lens includes a magnetic material in inductors in said unit cells.

### BRIEF DESCRIPTION OF THE DRAWINGS

Further aspects and advantages of the present invention will become apparent upon reading the following detailed description in conjunction with the accompanying drawings, in which:

FIG. 1 is a general block diagram of a Direct Magnetic Imager according to an embodiment of the present invention;

FIG. 2 is a general block diagram of a Direct Magnetic Imager according to a second embodiment of the present invention;

FIG. 3 is a general block diagram of a Direct Magnetic Imager according to a third embodiment of the present invention;

FIG. 4 is a general block diagram of a Direct Magnetic Imager according to a fourth embodiment of the present invention;

FIG. 5 is a block diagram illustrating a Direct Magnetic Imager according to an embodiment of the present invention illustrated in FIG. 3;

FIG. 6 is a block diagram of a Direct Magnetic Imager according to an embodiment of the present invention illustrated in FIG. 4;

FIG. 7 is a block diagram of a Direct Magnetic Imager according to an embodiment of the present invention illustrated in FIG. 3;

FIG. 8 is a block diagram illustrating a Direct Magnetic Imager which includes an imaging system which has been modified to include metamaterial lens structures according to an embodiment of the present invention;

FIG. 9 is a block diagram of a Direct Magnetic Imager including tunable metamaterial lens structure(s) according to an embodiment of the present invention illustrated in FIG. 3;

FIG. 10 is a block diagram of a Direct Magnetic Imager including tunable metamaterial lens structure(s) according to an embodiment of the present invention illustrated in FIG. 4;

FIG. 11 illustrates a method for direct magnetic imaging using metamaterial lens structure(s) according to embodiments of the present invention illustrated in FIGS. 1-4;

FIG. 12 illustrates an exemplary sensor which operates at room temperature and is used as a detector component in a Direct Magnetic Imager according to embodiments of the present invention illustrated in FIGS. 1-4;

FIG. 13 illustrates an exemplary MEMS device including multiple cantilever devices used for detection in a tunable Direct Magnetic Imager according to an embodiment of the present invention;

FIG. 14A illustrates imaging performance with an exemplary metamaterial lens according to an embodiment of the present invention, and FIG. 14B illustrates comparative imaging performance without a metamaterials lens;

FIGS. 14C and 14D illustrate wave propagation and enhancement in an exemplary metamaterial lens used in a Direct Magnetic Imager according to an embodiment of the present invention;

FIGS. 15A, 15B, 15C and 15D illustrate exemplary metamaterial lenses included in a Direct Magnetic Imager according to an embodiment of the present invention;

FIG. 15E illustrates details and performance of exemplary metamaterial lenses used in a Direct Magnetic Imager according to an embodiment of the present invention;

FIGS. 16A and 16B illustrate exemplary measured transmission of a coil without and with the fabricated metamaterial lens shown in FIG. 15A for use in a Direct Magnetic Imager according to an embodiment of the present invention; and

FIGS. 17A and 17B illustrate the change in normalized magnetic field intensity with a change in distance from an object to be imaged with a metamaterials lens used in a Direct Magnetic Imager according to an embodiment of the present invention.

### DETAILED DESCRIPTION

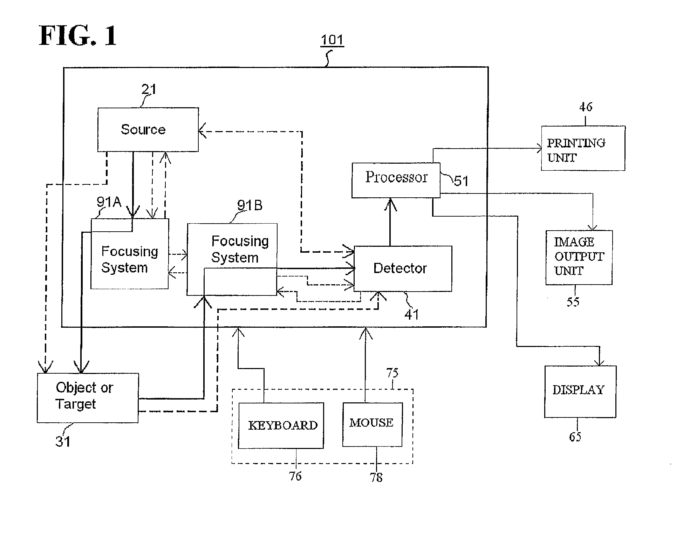

Aspects of the invention are more specifically set forth in the accompanying description with reference to the appended figures. FIG. 1 is a general block diagram of a Direct Magnetic Imager 101 according to an embodiment of the present invention. The Imager 101 illustrated in FIG. 1 includes the following components: a source 21; focusing systems 91 A and 91B; a detector 41; and a processor 51. Although the various components of FIG. 1 are illustrated as discrete elements, such an illustration is for ease of explanation and it should be recognized that certain operations of the various components may be performed by the same physical device, e.g., by one or more apparatuses or (micro)processors. Operation of the Imager 101 in FIG. 1 will become apparent from the following discussion.

Source 21 generates an electromagnetic field or radiation which is applied to an object or target 31. Source 21 may include one or more of a permanent magnet, a permanent magnet coil, a variable field magnet, an antenna, an RF transmitter or coils, or some other devices which produce an electromagnetic, magnetic, or electric field, radiation or wave pattern through an electrical, magnetic, mechanical or other type(s) of mechanism(s). In some applications, source 21 generates a low magnetic field which may be on the order of mT to µT. In other applications, source 21 generates a medium or a high magnetic field of the order of Tesla.

Object 31 may be a person, an anatomical part, an inanimate item to be analyzed such as a vehicle, cargo, an environmental structure, etc. Target 31 may be an item that needs to be screened for presence or absence of certain substances or structures, such as, for example, a suspected explosive, a piece of luggage, a container with suspected substances, a suspected weapon or a case that might contain a weapon, a chemical or pharmaceutical composition or container thereof, etc.

Focusing system 91A concentrates the electromagnetic, magnetic or electric field/signal/waves generated by source 21 to object/target 31. Focusing system 91B receives a signal, radiation or field/field signature from object/target 31 and concentrates the signal, radiation or field/field signature to detector 41.

Focusing systems 91A and 91B include one or more metamaterial lens(es) or lens array(s) to concentrate the input and the output fields and decrease the need for shielding, subject proximity, and field strength, while maintaining imaging resolution. A metamaterial lens enables a focusing effect, allowing focusing down radiation below the typical diffraction limited spot and opening new applications for direct imaging of magnetic fields and long wavelength fields including RF fields. The term "metamaterial lens structure" is used herein to designate one or more metamaterial lenses and/or metamaterial lens array(s).

A metamaterial lens is an engineered device which has a refractive index (*n*) equal to minus one, or a magnetic permeability (*mu*) or electric permittivity (*epsilon*) equal to minus one. A metamaterial lens is made of unit cells which provide specific advantageous lensing properties. For a magnetic metamaterial lens, in the quasi-magnetostatic limit, only *mu* could be equal to minus one in order for the metamaterial lens to act as a magnetic focusing device and achieve super resolution. Such magnetic metamaterial lens can focus into discrete areas of the object or target 31 and provide super resolution through direct magnetic imaging. For an electric metamaterial lens, in the quasi-electrostatic limit, only *epsilon* could be equal to minus one in order for the metamaterial lens to act as an electric focusing device and achieve super resolution. In the general case where *n* equals to minus one, the metamaterial lens acts as both a magnetic and electric field focusing device and achieves super resolution.

Metamaterial lens structures 91A and 91B in FIG. 1 may implement various applications or techniques that require imaging or magnetic and RF fields. Such applications or techniques include direct magnetic imaging for MRI and Nuclear Magnetic Resonance (NMR) spectroscopy applications, direct imaging of magnetic and long wavelength fields including RF fields, SQUID-based (super quantum interference detector) low field systems and other magnetic applications. The Imager of the present invention illustrated in FIG. 1 is applicable to low-magnetic fields imaging (in the kHz range), in which SQUID detectors or uncooled magnetometer detectors are used as detector elements. The Imager of the present invention may also be applied to the electric component of the EM field. For example, the Imager may be an application in the optical and/or IR range in which a metamaterial lens with *epsilon = -*1 or *n* = -1 is used with the electric component of the EM field.

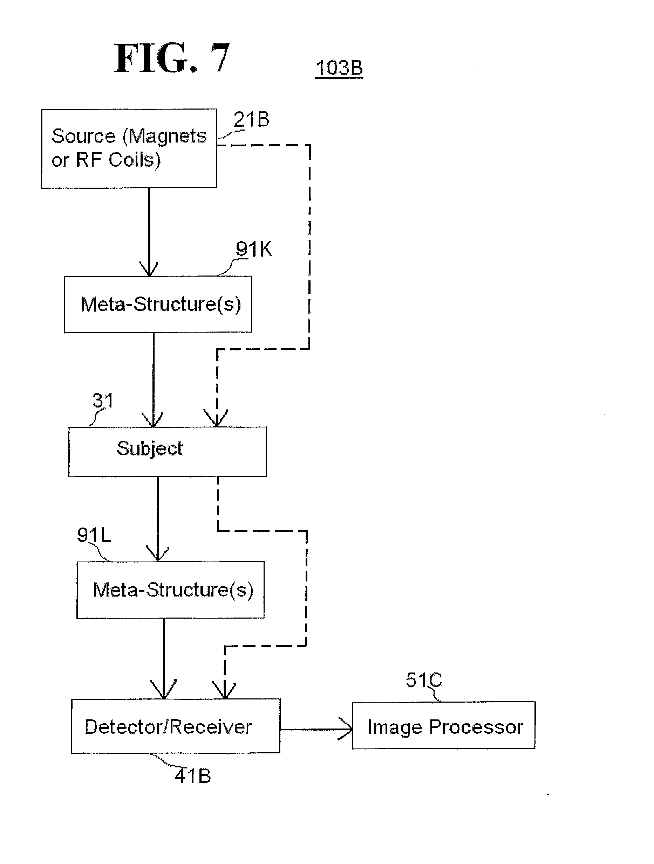

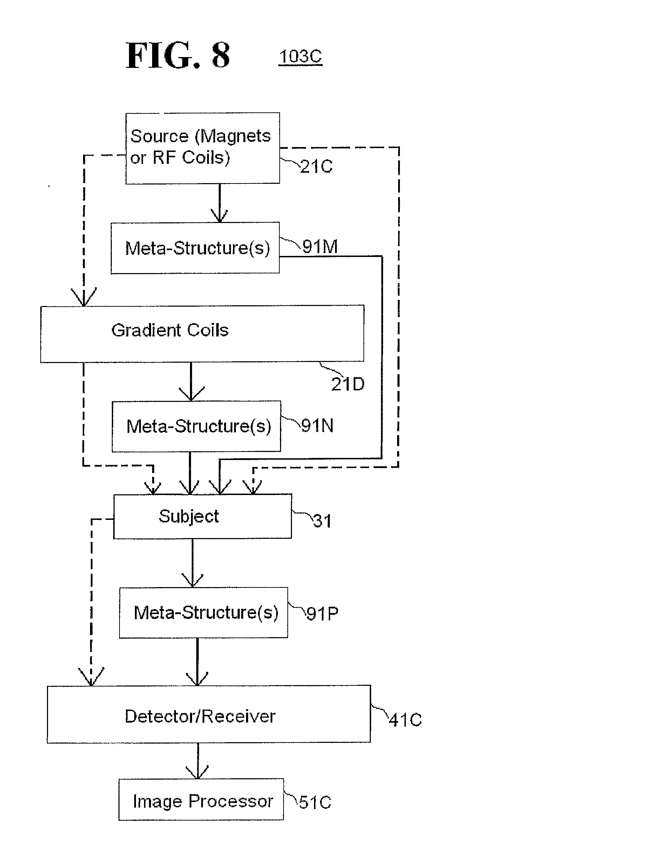

In an exemplary embodiment of the present invention illustrated in FIG. 7, metamaterial lens structures replace the gradient coils that are used in traditional imagers, such as MRI units, to encode the RF signal in each spatial dimension. The metamaterial lens structures thus allow directing and focusing down the RF fields into discrete areas in a subject, to enable direct magnetic imaging which is analogous to optical imaging. In another exemplary embodiment described in FIG. 8, metamaterial lens structures are added to a state-of-the-art imaging system to collect and focus the signal into the RF receiver coils and/or into a magnetometer detector and improve sensitivity and detector SNR.

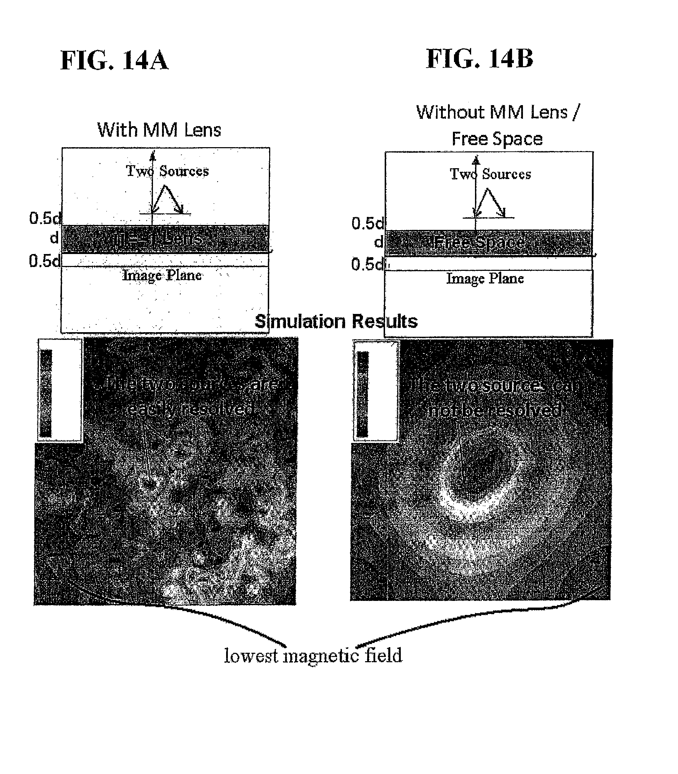

The metamaterial lens structures offer many imaging advantages including improved resolution, increased sensitivity, decreased acquisition time, and enhanced signal to noise ratio. The large Q-value and narrow bandwidth of metamaterial lens structures increase detector SNR, reduce shielding requirements, stand-off distance limitations and field strength requirements, while significantly improving imaging resolution. Details of exemplary metamaterial lens structures are presented in FIGS. 14A-14D, 15A-15E, 16A-16B and 17A-17B which are described in more detail in below.

Metamaterial lenses decrease the need for shielding due to their ability to concentrate the field into the object/target, and then subsequently into the detector. This boosts the signal part of SNR (>5x, in exemplary embodiments) to overcome the noise component, since the signals from the object/target area of interest are concentrated more strongly from the area of interest, which also reduces the need for shielding from stray magnetic fields. The original field strength may then be decreased, depending on application output requirements. By contrast, in traditional imaging systems such as state-of-the-art MRI systems, the signal is boosted by increasing the magnetic field strength, and significant shielding is needed to remove external magnetic background and noise from detector and bring the SNR to an acceptable value.

The metamaterial lens structures better concentrate the input and output signal, and therefore the stand-off distance from the area of interest within an object/target (i.e., how far away from the Imager device the object/target can be placed, whereby the Imager still performs imaging) and the distance between the device and the object/target can be increased without decreasing the ability of the Imager to image the object/target area of interest. The object/target may also be in direct contact with the Imager, depending on the application. Thus, the Imager provides significant flexibility for positioning the object/target relative to the imaging device.

Detector 41 obtains data from focusing system 91B, performs analysis of received data, and outputs the results to processor 51. Detector 41 may include electrical, magnetic and mechanic components and combination devices such as MEMS devices, magnetometers, magnetorestrictive devices, SQUID detectors, antennas, RF coils, atomic magnetometers, MEMS magnetometers, magnetorestrictive MEMS devices, etc. Other electrical, magnetic and mechanic sensors may also be included in detector 41.

Processor 51 processes the data from detector 41 and outputs a representation, such as, for example, a graphical representation of the imaged object or target area, or other type of reconstruction data. Processor 51 may include one or more microprocessors, purpose built hardware such as, for example, FPGA, ASIC, etc., software systems and applications, software packages, etc. Software packages that may be part of processor 51 may be recorded on a computer readable medium such as a memory device, RAM, CD/DVD/USB drives, etc., and/or may be part of a physical device such as one or more (micro)processors.

A user, e.g., a medical professional, military or security personnel, etc., may control parameters associated with the source 21, focusing systems 91A and 91B, detector 41 and processor 51 and may view the output of processor 51 via a display 65 or other device that produces representations of the output of processor 51, such as a printing unit 46 or an image output unit 55. The user may input commands to the Imager 101 via a user input unit 75. In the embodiment illustrated in FIG. 1, the user input unit 75 includes a keyboard 76 and a mouse 78, but other conventional input devices could also be used. Elements of the Imager 101 may also be controlled automatically.

Printing unit 46 receives the output of processor 51 and generates a hard copy of the processed image data. In addition to or as an alternative to generating a hard copy of the output of the processor 51, the processed image data may be returned as an image file, e.g., via a portable recording medium or via a network (not shown). The output of processor 51 may also be sent to image output unit 55 that performs further operations on image data for various purposes. The image output unit 55 may be a module that performs further processing of the image data, a database that collects and compares images, etc.

Focusing system 91A may be bypassed, so that the signal/radiation/field from source 21 reaches the object/target 31 directly from source 21. Alternatively, a first signal/radiation/field from source 21 may directly reach object/target 31, while a second signal/radiation/field from source 21 may be focused by meta-structure 91A to concentrate the second signal/radiation/field onto object/target 31.

Similarly, focusing system 91B may be bypassed, so that the signal/radiation/field from object/target 31 reaches the detector 41 directly from object/target 31. Alternatively, a first signal/radiation/field from object/target 31 may directly reach detector 41, while a second signal/radiation/field from object/target 31 may pass through meta-structure 91B before reaching detector 41.

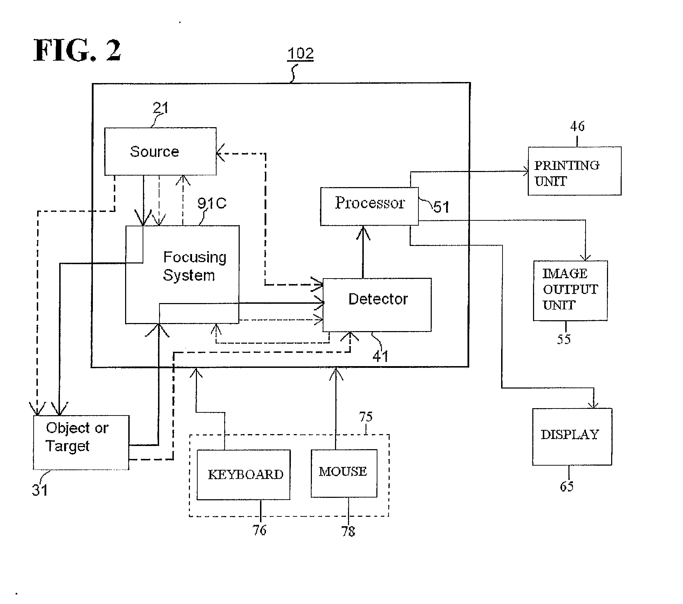

FIG. 2 is a general block diagram of a Direct Magnetic Imager 102 according to a second embodiment of the present invention. The system 102 illustrated in FIG. 2 includes the following components: a source 21; a focusing system 91C; a detector 41; and a processor 51. Focusing system 91C is in the path of the electromagnetic field created by source 21 and performs a focusing function on the field/radiation/signal onto the object/target 31. Focusing system 91C also receives a signal, radiation, or field signature from object/target 31 and focuses it onto detector 41.

Detector 41 performs analysis of the received data, and outputs the results to processor 51, which outputs a representation, such as, for example, a graphical representation of the imaged object or target area, or other type of reconstruction data.

In one embodiment, a first signal/radiation/field from source 21 directly reaches object/target 31, while a second signal/radiation/field from source 21 is focused through focusing system 91C before reaching object/target 31. Also, a first signal/radiation/field signature from object/target 31 may directly reach detector 41, while a second signal/radiation/field signature from object/target 31 may be focused by focusing system 91C onto detector 41.

Focusing system 91C includes one or more metamaterial lens(es) or lens array(s) to focus magnetic fields. Metamaterial lens structure 91C may implement various imaging applications such as direct magnetic imaging for MRI and Nuclear Magnetic Resonance (NMR) spectroscopy applications, direct imaging of magnetic and long wavelength fields including RF fields, SQUID-based (super quantum interference detector) low field systems and other magnetic applications. The present invention illustrated in FIG. 2 is also applicable to low-magnetic fields (in the kHz range), in which SQUID or uncooled magnetometer detectors may be used for detector 41. The Imager illustrated in FIG. 2 can also be applied to the electric component of the EM field, to focus the electric component using one or more metamaterial lens(es) or array(s) which form the focusing system 91C.

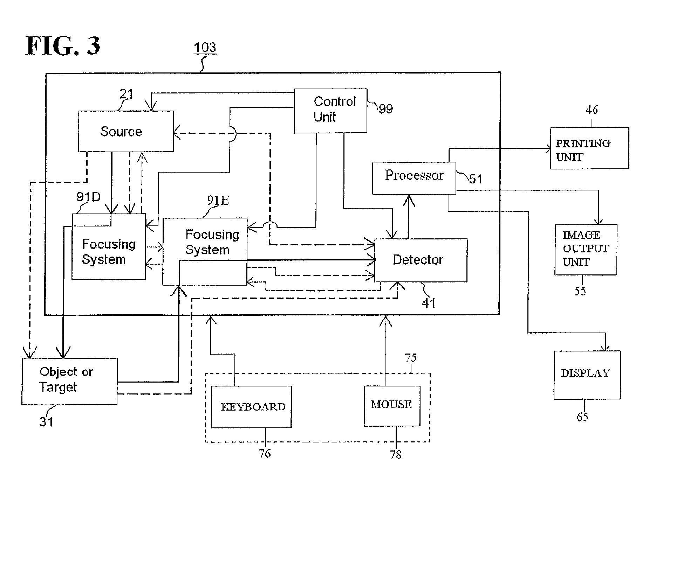

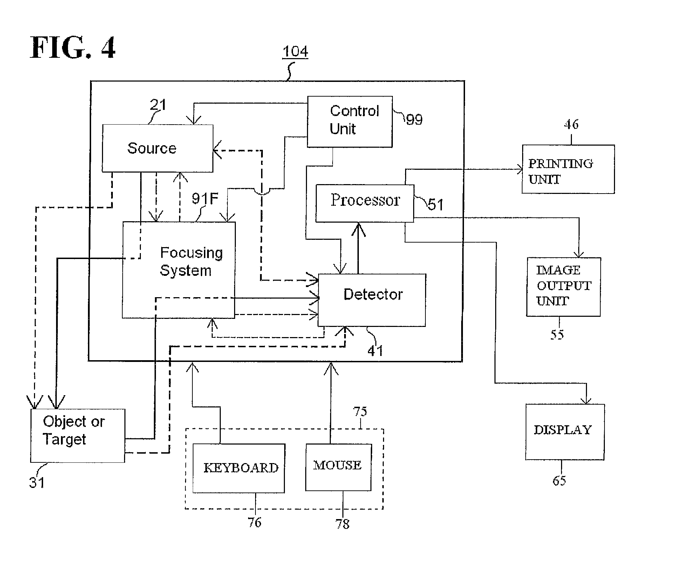

FIG. 3 is a general block diagram of a Direct Magnetic Imager 103 according to a third embodiment of the present invention. The Direct Magnetic Imager 103 illustrated in FIG. 3 includes: a source 21; focusing systems 91D and 91E; a detector 41; a processor 51; and a control unit 99. FIG. 4 is a general block diagram of a Direct Magnetic Imager 104 according to another embodiment of the present invention. The Direct Magnetic Imager 104 illustrated in FIG. 4 includes: a source 21; a focusing system 91 F; a detector 41; a processor 51; and a control unit 99.

In accordance with these third and fourth embodiments of the present invention, the source 21, focusing systems 91D, 91E and 91F, detector 41 and processor 51 may function in like manner to the corresponding elements of the first and second embodiment. In accordance with the third and fourth embodiments illustrated in FIGS. 3 and 4, control unit 99 controls one or more of the following units: focusing systems 91D, 91E and 91F, source 21 and detector 41. Control unit 99 may, for example, control and adjust focusing parameters and tuning parameters in focusing systems 91D, 91E and 91F, source 21 and detector 41. For example, control unit 99 may adjust focusing parameters and frequency tuning parameters for the metamaterial lens(es) or metamaterial lens array(s) in the focusing systems 91D, 91E and 91F, depending on parameters of source 21 and/or detector 41.

Control unit 99 may include one or more microprocessors, purpose built hardware such as, for example, FPGA, ASIC, etc., software systems and applications, software packages, etc. Software packages that may be part of control unit 99 may be recorded on a computer readable medium such as a memory device, RAM, CD/DVD/USB drives, etc., and/or may be part of a physical device such as one or more (micro)processors. Control unit 99 may be a standalone unit, or may be incorporated into one or more focusing systems, source and detector, or may include multiple units each incorporated in a focusing system, source and detector. For example, control unit 99 may be composed of a plurality of control units, each included in source 21, focusing systems 91D, 91E, 91F, and detector 41, respectively, so that source 21 communicates with focusing systems 91D or 91F, detector 41 communicates with focusing systems 91E and 91F, and focusing systems 91D and 91E communicate with each other, to reciprocally adjust parameters and settings.

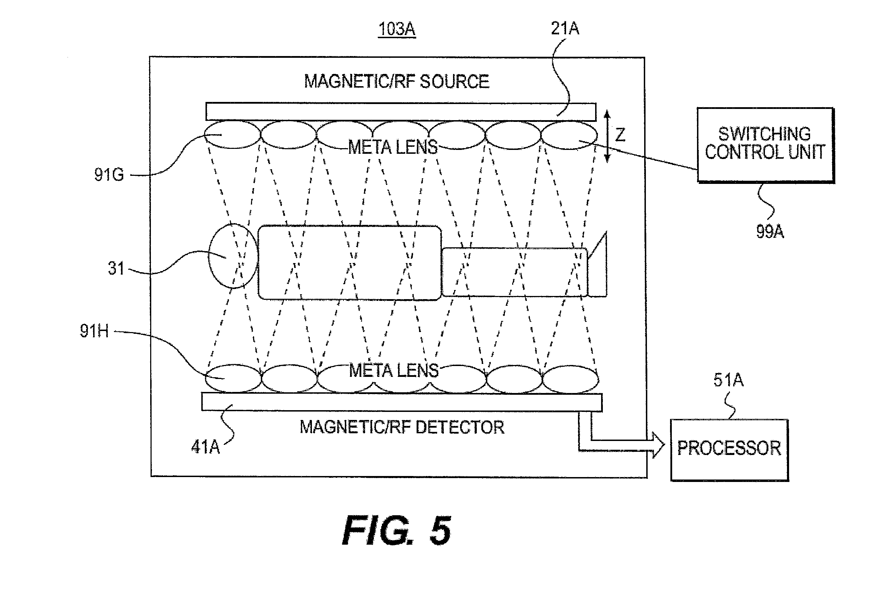

FIG. 5 is a block diagram illustrating a Direct Magnetic Imager 103A according to an embodiment of the present invention illustrated in FIG. 3. The Direct Magnetic Imager 103A illustrated in FIG. 5 includes a magnetic/RF source 21A, metamaterial lens(es) or lens arrays 91G and 91H, magnetic/RF detector 41A, processor 51A, and switching control unit 99A. Source 21A may include magnets, antennas, RF coils, as well as other components. Detector elements included in magnetic/RF detector 41A may be SQUID detectors, atomic magnetometers, cooled and uncooled magnetometers, MEMs magnetometers, antennas, RF coils/receivers, etc. The object or target 31 may be a person, an anatomical part, explosives, cargo, weapons, vehicles, etc.

The metamaterial lens structure 91G focuses down radiation and/or magnetic fields from magnetic/RF source 21A into object/ target 31. Metamaterial lens structure 91H focuses and collects the signal emitted by object/target 31 to magnetic/RF detector 41A. Changes in focusing depth of metamaterial lens structure 91 G are achieved via mechanical or electrical switching of the meta-lens array 91 G, by switching control unit 99A. The focusing volume of metamaterial lens structures 91G and 91H determines resolution of Imager 103A and may provide a one-to-one correspondence between the pixelated source plane and the image plane.

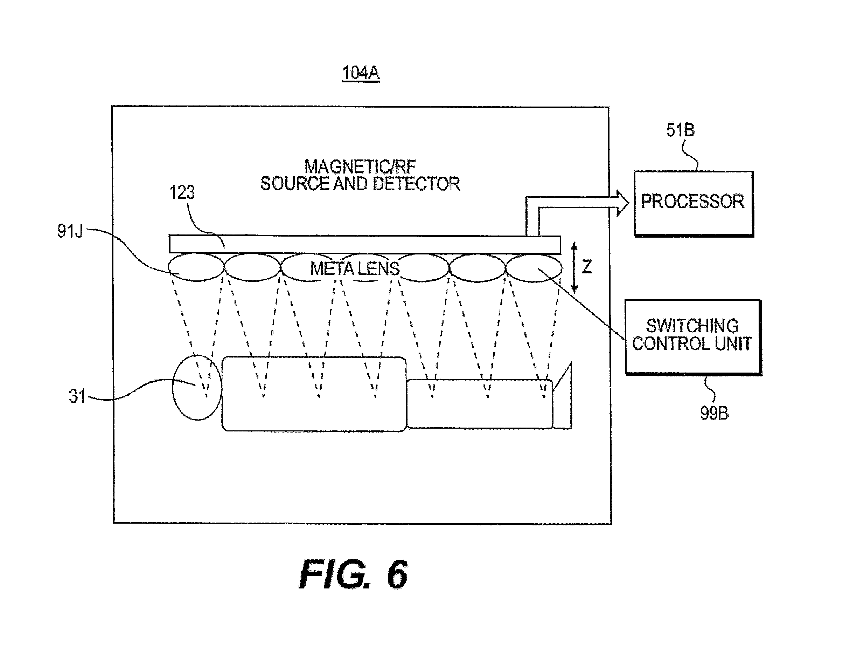

FIG. 6 is a block diagram of a Direct Magnetic Imager 104A according to an embodiment of the present invention illustrated in FIG. 4. The Direct Magnetic Imager 104A illustrated in FIG. 6 includes a magnetic/RF source and detector 123, metamaterial lens(es) or metamaterial lens array(s) 91J, processor 51B and switching control unit 99B. Sources in unit 123 may include magnets, antennas, and RF coils. Detector elements included in unit 123 may include SQUID detectors, atomic magnetometers, cooled and uncooled magnetometers, MEMs magnetometers, antennas, and RF coils/receiver. The object/ target 31 may be a person, an anatomical part, explosives, cargo, weapons, vehicles, etc.

Magnetic/RF source and detector 123 may be one unit that performs the functions of source and detector at the same time. Magnetic/RF source and detector 123 may also include multiple units, each dedicated to be either a source or a detector. For example, a transmitter (source) and a receiver (detector) in unit 123 may be located in the same plane, or at positions that are adjacent to each other.

Metamaterial lens structure 91J focuses down radiation and/or magnetic fields from the magnetic/RF source 123 into object/target 31 and focuses back and collects the signal emitted by object/target 31 to the detector 123. Changes in the focusing depth for metamaterial lens structure 91J are achieved via mechanical or electrical switching of the meta-lens array by switching control unit 99B. Resolution of the imager 104A is determined by the focusing volume of metamaterial lens structure 91J.

In an exemplary embodiment, a permanent magnet may be used in the source 21A/123 in FIGS. 5 and 6, to first align the protons in the object/target 31. This magnetic field can be permanent or it can be terminated at any time during the imaging procedure. An AC magnetic field, which may be at the Larmor's frequency/ frequencies of element(s) in object/target 31, is then applied to achieve proton precession. The metamaterial lens structures 91G and 91J focus the field down into object/target 31, while metamaterial lens structure 91H collects the signal to receiver 41A, or the same metamaterial lens structure 91J collects the signal back to receiver 123. These systems perform direct imaging like an optical imaging system, and 3D spatial information is obtained by re-focusing the metamaterial lens(es) into different dimensions. For example, the metamaterial lens(es) may be re-focused along the z-axis. Re-focusing may be performed in other directions as well, separately or simultaneously. The output signal is used to create an actual magnetic image into detector 41A/123.

The Direct Magnetic Imaging apparatuses of the present invention offer multiple advantages, as they facilitate direct magnetic imaging in MRI and NMR applications, including portable MRI and NMR systems. Alternate, non-portable configurations and applications may also be implemented. Non-portable applications include traditional clinical MRI machines (e.g. 3T, 1.5T) in which the metamaterial lens is used as an add-on/external component to the MRI machine to concentrate/focus the magnetic fields into areas of interest inside the body allowing to increase the signal to noise ratio. Prostate imaging is a good example of an application for a modified MRI machine including a metamaterial lens. Another example is the use of the metamaterial lens as a replacement of the gradient coils in the traditional non-portable MRI machines.

In another exemplary embodiment illustrated in FIG. 7, the metamaterial lens structure replaces the gradient coils which are typically used in MRI units, for example, to encode the RF signal in each spatial dimension. The imaging system of FIG. 7 thus allows focusing of the RF fields for direct imaging applications. The Imager in FIG. 7 includes a source 21B which may be magnets or RF coils which pre-polarize the atoms, a metamaterial lens structure 91K which focuses a field from source 21B into a subject 31, and another metamaterial lens structure 91L which focuses a signal/field from subject 31 into the detector/receiver 41B which may be an RF coil or a magnetometer. In one embodiment, one of metamaterial lens structures 91K and 91L may be bypassed. Detector/receiver 41B may detect a change in the magnetic field (for example, by looking for resonance) or spatially map magnetic fields received from subj ect 31. The change in magnetic fields detected by detector/receiver 41B is a function of the input field applied. In exemplary embodiments, the field change detected by detector/receiver 41B may be of the order of µT, mT, or Tesla. The detector /receiver 4 1 B may include an RF receiver for MRI, SQUID detectors, and cooled and uncooled magnetometers to collect the signal, for additional applications.

Co-pending US Application No. 12/801,799 filed on June 25, 2010, the entire contents of which are being hereby incorporated by reference, describes a BioMagnetic Imager which includes metamaterial lens structures and can be used for detection of anatomical features. In an exemplary embodiment in US Application No. 12/801,799, one or more metamaterial lens structures concentrate an ultra low magnetic field to a person of interest, and then concentrate the magnetic signature from the person into to a detector. A contrast agent may be applied to the subject for detection of a signature of a certain type of anatomical change, or to a non-biological subject (for example, for magnetic imaging for border patrol or underwater vehicle sensing) for detection of a change in a material characteristic or for materials characterization.

As mentioned before, traditional magnetic imaging approaches, whether in high field or low field, do not use a "direct" magnetic imaging approach to produce an image. Traditional MRI approaches are limited by the fact that RF wavelengths (in the meter range) cannot focus down to the resolution spot size that is required for diagnostic and spectroscopic purposes. The conventional approach for increasing resolution in an MRI system is to increase the magnetic field strength, with the drawback that the higher magnetic field systems are more costly, bulkier, and require additional infrastructure. For instance, a 3 Tesla MRI system costs ~$3M, while a 1.5 Tesla MRI system costs ~$1.5M; thus, the traditional MRI imaging approach has limited capability to increase sensitivity and decrease the acquisition time. For these reasons, traditional magnetic imaging approaches have limited applicability.

The direct magnetic imaging approach described in the present invention enables new applications such as high resolution portable MRI systems and adjacent market applications such as airport security, underwater vehicle detection, etc., by integrating a metamaterial lens system in a traditional magnetic imager, as is shown in FIG. 8. In the Imager of FIG. 8, gradient coils are used with the metamaterial lens, which acts as a concentrator to enhance SNR. In FIG. 7, the gradient coils are replaced by the metamaterial lens, taking advantage of the super resolution offered by the lens to be able to image localized areas in the object/subject without the need for the gradient coils to provide the spatial encoding.

Imager 103C in FIG. 8 includes an imaging system, which may be an MRI system, which has been modified from its traditional form, to include metamaterial lens structures. In order to obtain reasonable resolution for an MRI application, the meter long wavelengths are focused down to millimeter sizes (-on the order of lambda/1000) by the metamaterial lens structure.

A metamaterial lens structure may also used as an external component added to traditional NMR systems, traditional SQUID-based low field systems and other magnetic applications, to improve sensitivity and detector SNR, without altering the underlying system configuration. Each atomic nuclei (all materials) have a distinct signature that is largely unperturbed by surrounding environment. These distinct signatures could be detected through NMR if the signal-to-noise ratio (SNR) becomes good enough to interpret the signature. For traditional NMR spectroscopy, the signal to noise ratio is limited by the strength of the magnetic response of the multiple atoms composing the sample. Identification is performed by discriminating among the different Larmor's frequencies associated with the sample. Physical techniques (e.g. sample rotation) need to the employed in order to boost the SNR, making the traditional NMR technique only useful in laboratory settings.

When a metamaterial lens system is integrated in an NMR imaging system and is tuned to the desired Larmor frequencies, a focused signal into the object/target and/or into the receiver is created. The meta-structures focus down radiation below the typical diffraction limited spot and enable detection of distinct signatures of nuclei or atoms through NMR, by boosting the signal portion without the need for boosting the magnetic field, to obtain a high SNR and interpret the signature. Detection provided by the metamaterial lens structure enables identification of biological changes and non-biological materials and chemicals even when the materials and chemicals are embedded inside other objects.

The use of a metamaterial lens structure in a traditional MRI or NMR or other magnetic system improves sensitivity and signal to noise ratio without altering the basic system configuration. The Fourier Transform is still used to reconstruct the image in the MRI system. The detector /receiver in such a modified MRI/NMR system may include an RF receiver for MRI, and may also include SQUID detectors, and cooled and uncooled magnetometers to collect the signal, for additional applications.

An MRI system includes a magnet, gradient coils, and RF receivers. A signal is obtained by the RF receivers by applying an AC magnetic field (RF field) corresponding to the hydrogen's Larmor frequency. In the embodiment illustrated in FIG. 8, metamaterial lens structure 91P collects and focuses the signal into detector/ receiver 41C, metamaterial lens structure 91N focuses the signal from gradient coils 21D into a subject 31. Another metamaterial lens structure 91 M focuses the signal from source 21C into subject 31. In alternative embodiments, one or two metamaterial lens structures among 91M, 91N and 91P may be omitted. In exemplary embodiments, source 21C includes magnets and/or RF coils, and detector/ receiver 41C may be a MRI detector/receiver, and/or may include an RF coil or a magnetometer.

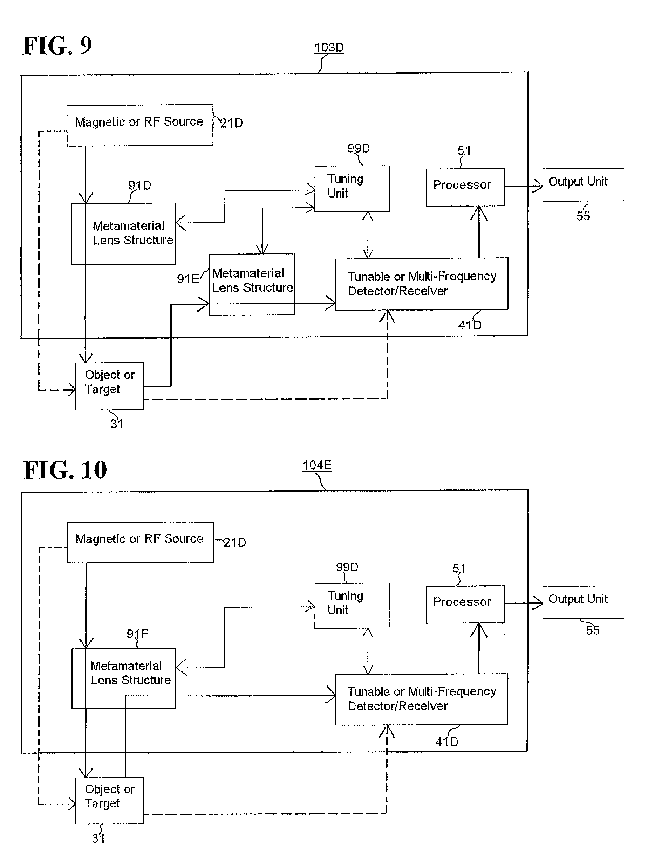

In other exemplary configurations, a tunable/multi-frequency magnetometer (e.g., a MEMS based magnetometer) detector is used in conjunction with metamaterial lens structures which are tuned to one or more specific collecting frequencies of the sensor, to increase sensitivity, SNR and applicability, and to reduce the need for shielding and high magnetic fields. Such Imagers are illustrated in FIGS. 9 and 10, in which a tuning unit 99D communicates with metamaterial lens structures 91D, 91E and 91F and with tunable multi-frequency detector/receiver 4 1 D for tuning to the specific collecting frequency or frequencies of the detector/receiver. The tuning unit 99D may be a standalone unit, or may include multiple units incorporated in the metamaterial lens structures and/or in the detector/receiver. In one embodiment, only one metamaterial lens structure in FIG. 9 is tunable.

In an exemplary embodiment, the components of the Direct Magnetic Imager system are tuned to specific frequencies to facilitate NMR type applications by tuning to the desired Larmor frequencies. In such systems, a tuning unit may communicate with one or more metamaterial lens structures, with the NMR source and/or with the detector, to tune to specific frequencies associated with desired Larmor frequencies of one or more elements in the object or target. The resonance of the Imager may also be selected based on the external magnetic field strength, frequency of an RF coil included in the detector and/or frequency of an RF gradient coil used to interrogate the sample/subj ect in order to obtain information.

Magnetic resonance can be tuned to specific elements, in which case the frequency response will change based on applied field strength, by orders of magnitude. The Direct Magnetic Imager including metamaterial lens structures enables precise tunability in the input/output signal, allowing for imaging to be tuned to specific elements other than hydrogen. Tunability may be provided by tunable elements included in/on the lens, or by a stacking of metamaterial lenses where each lens is tuned to a specific frequency or frequency range and has a narrow operating bandwidth, and each metamaterial lens can be selected based on the desired frequency response, by tuning through the field range. Thus, the resonance of the Imager can be switched through an entire field range. The detector may also be designed to detect in multiple frequencies or frequency ranges. The range or magnitude of magnetic fields from the source, and the spatial or frequency-dependent characteristics of the detector can be selected in connection with the resonant frequencies to be detected by the Imager, to improve tunability of the device. The Imager of the present invention can be used to select resonance signals based on an external magnetic field strength as well as frequency of detector and/or frequency of a device used to interrogate the sample/subject in order to obtain information. Currently, no other imaging technique has the capability to enable precise tunability while allowing for imaging to be tuned to specific elements other than hydrogen.

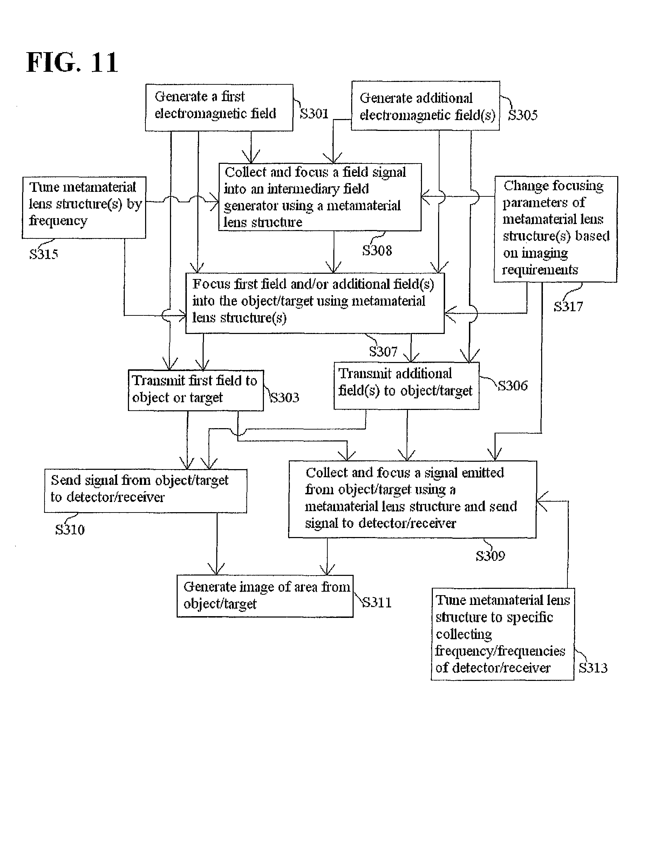

FIG. 11 illustrates a method for direct magnetic imaging using metamaterial lens structure(s) according to embodiments of the present invention illustrated in FIGS. 1-4. A first electromagnetic field is generated (S301) and transmitted to an object or target (S303). Additional electromagnetic fields may be generated (S305) and sent to object/target (S306) to superimpose with the original field and cause specific changes in the object/target. In an exemplary embodiment, the first field may be a static magnetic field, and the additional field may be a transient RF wave which is superimposed on the static field. The first field and/or the additional fields may be focused by metamaterial lens structure(s) into the object/target (S307). A metamaterial lens structure may also collect and focus a field signal into an intermediary field generator (S308), such as a generator of RF waves. A metamaterial lens structure may also collect and focus a signal emitted from the object/target and send the signal to a detector/receiver (S309) which creates an actual image of an area in the object/target (S311). The metamaterial lens structure may be tuned to specific collecting frequency/frequencies of the sensor (S313). The signal from object/target may also be sent directly to the detector/receiver (S310).

The other metamaterial lens structures may also be tuned in frequency (S315). Focusing parameters of the metamaterial lens structures may be changed based on imaging requirements (S317).

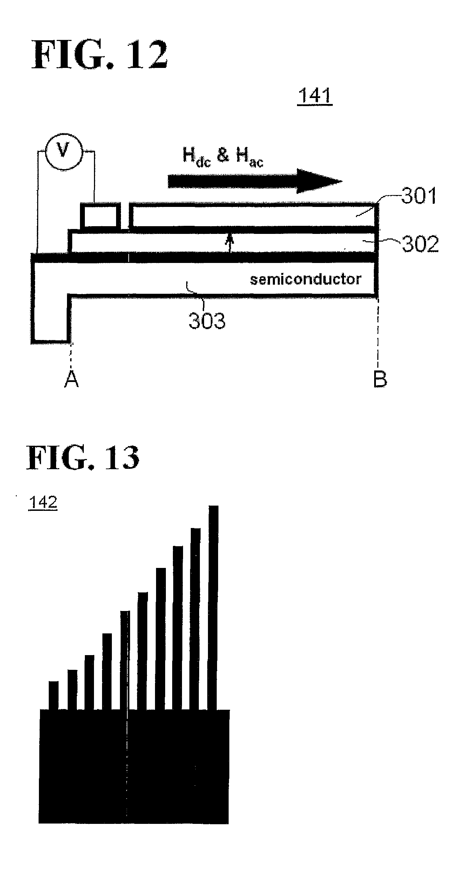

FIG. 12 illustrates a sensor 141 which operates at room temperature and may be used as a detector component in a detector 41 of a Direct Magnetic Imager according to embodiments of the present invention illustrated in FIGS. 1-4. The sensor in FIG. 12 is a magnetorestrictive sensor which includes a magnetoelectric multilayer portion including layers 301, 302 and 303. Layer 303 is a semiconductor material such as silicon.

In an exemplary embodiment of the sensor 141, layer 301 may be a FeGa layer and layer 302 may be a piezoelectric material such as, for example, PZT. In the exemplary embodiment, the length of the sensor between points A and B is ~20mm, the cantilever thickness is on the order of 10's of microns, the thickness of layer 301 is ~1.5 micron and the thickness of layer 302 is ~1.5 micron.

In an exemplary embodiment, a MEMS device in the detector is a cantilevered, thin film coated magnetorestrictive device. Such detector component has a performance comparable to that of a SQUID device used currently in low field MRI, but does not require the cryogenic cooling required by SQUID devices, thus reducing the power and cooling required to run the imager. Such exemplary magnetorestrictive sensors have shown room temperature sensitivity down to 10⁻⁷ to 10⁻¹⁰ Tesla.

In an exemplary embodiment, the detector component may be a low magnetic field detector in the range of sub-µT, which operates at room temperature and provides high sensitivity comparable to, or higher than, the sensitivity of a cooled SQUID device. In other exemplary embodiments, the detector component may be a high magnetic field detector in the range of Tesla, or a medium magnetic field detector.

Exemplary magnetorestrictive sensors that may be used as a sensor in the Direct Magnetic Imager of the present invention are described in US Patent Application Publication US 2007/0252593 A1 (US Patent 7,345,475) by Takeuchi et al, the entire contents of this patent being hereby incorporated by reference.

The sensor illustrated in FIG. 12 is a magnetorestrictive sensor that operates at room temperature and can replace cryo-cooled SQUID based MRI systems, to reduce power usage and packaging size and volume for the Imager. Unoptimized sensors have already shown ability to detect sub-µT magnetic fields. Optimization of the sensor performance has also been achieved, further improving the sensitivity to enhance the imaging capabilities the Imager of the present invention for enhanced imaging performance in any field location, coupled with the ability to image areas of arbitrarily small size. In exemplary embodiments, the Imager of the present invention can image areas in cm, mm or sub-mm ranges. In an exemplary embodiment, imaging to a focal spot of ~1cm was demonstrated. The magnetic fields may vary from high fields (such as 3T) to ultra-low fields (e.g., micro-T).

FIG. 13 illustrates a MEMS device 142 including multiple cantilever devices for use in a tunable Direct Magnetic Imager according to an embodiment of the present invention. The MEMS device 142 can be used as a detector component in a detector 41, in connection with metamaterial lens structures which are tuned to one or more specific collecting frequency or frequencies of the sensor. These frequencies depend on the length of the cantilevers in sensor 142.

FIG. 14A illustrates imaging performance when a metamaterial lens is used according to an embodiment of the present invention, and FIG. 14B illustrates comparative imaging performance without a metamaterial lens. As can be seen in FIGS. 14A and 14B, two sources which cannot be resolved without a metamaterial (MM) lens, are easily resolved when the imaging is performed using the MM lens.

Inclusion of a metamaterial lens has already been shown to give a 10X signal improvement in simulations, and a 4X signal improvement has been experimentally shown. The magnetically hyperspectral metamaterial device/solution which includes lens tunability to certain frequencies or to other imaging parameters may surpass the performance of one metamaterial lens. The magnetically hyperspectral device is a tunable metamaterial lens or a stacking of metamaterial lenses designed for specific frequencies and which can be turned on and off in order to probe at different frequencies.

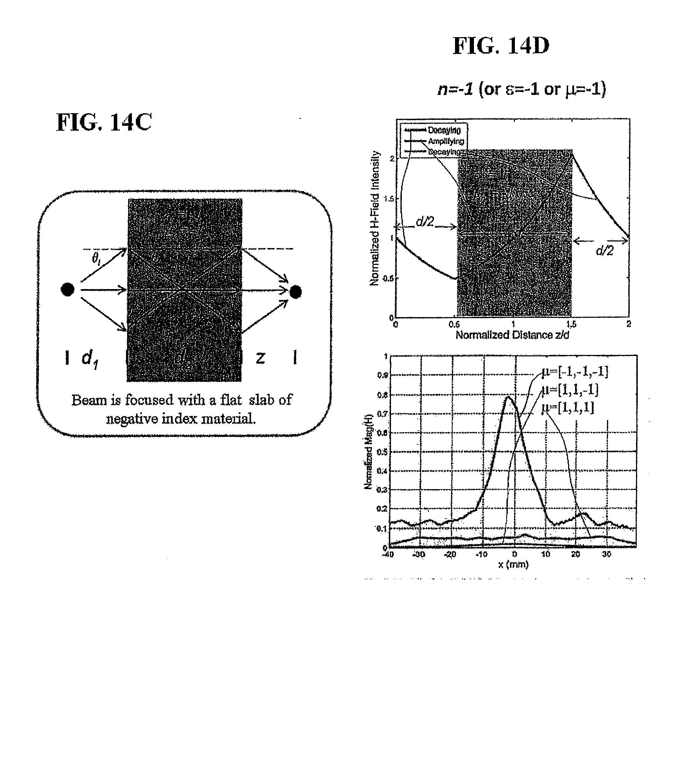

FIGS. 14C and 14D illustrate wave propagation in an exemplary metamaterial lens used in a Direct Magnetic Imager according to an embodiment of the present invention. The exemplary metamaterial lens in FIGS. 14C and 14D is described in publication "Negative Refraction Makes a Perfect Lens", by Pendry, Physical Review Letters, Vol. 85 (18), October 2000, pp. 3966-3969, the entire contents of this publication being hereby incorporated by reference. The wave propagation patterns in FIGS. 14C and 14D are for a Negative Index Metamaterial (NIM) with n or µ = -1 (ε=µ= -1) metamaterial lens. As can be seen in FIGS. 14A-14D, metamaterials enable enhanced imaging performance/resolution while decreasing the need for shielding, subject proximity and field strength.

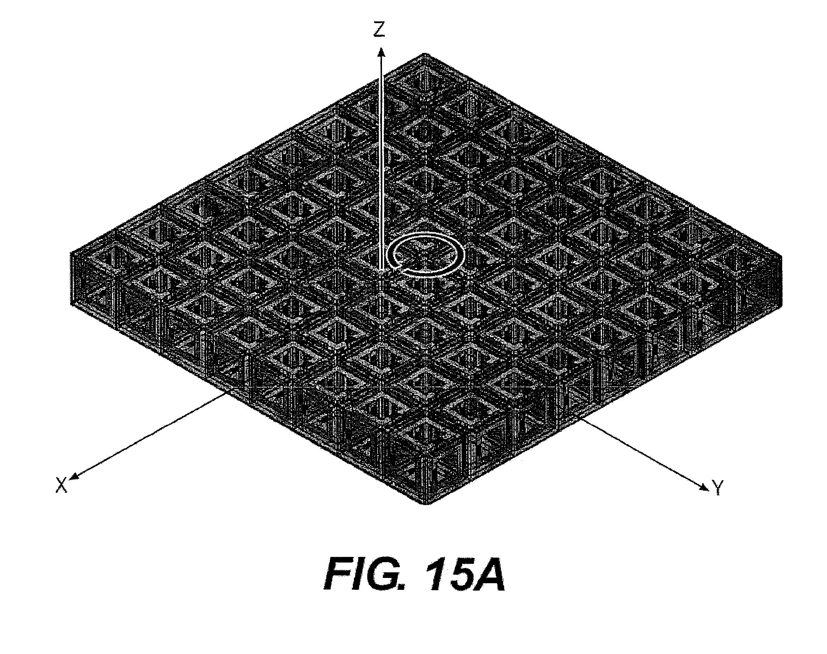

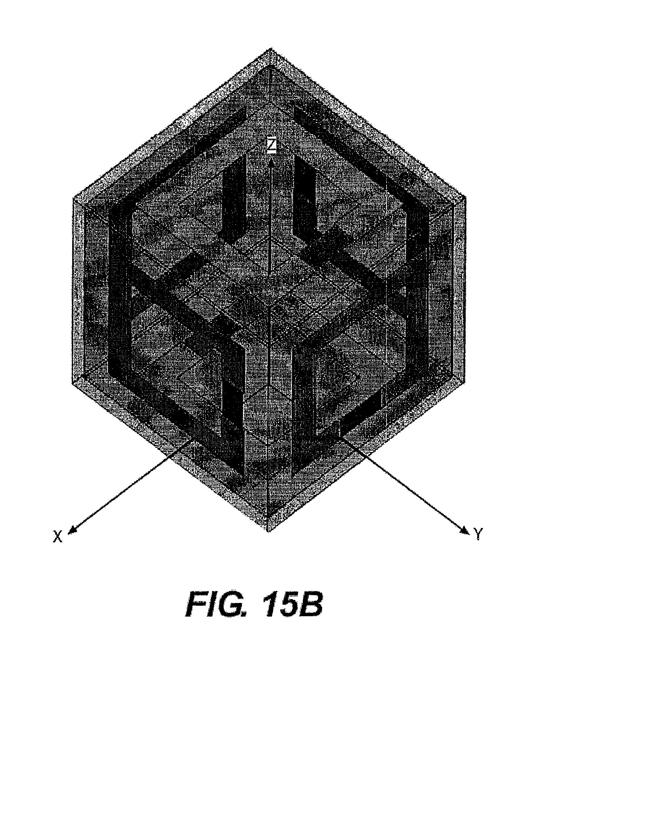

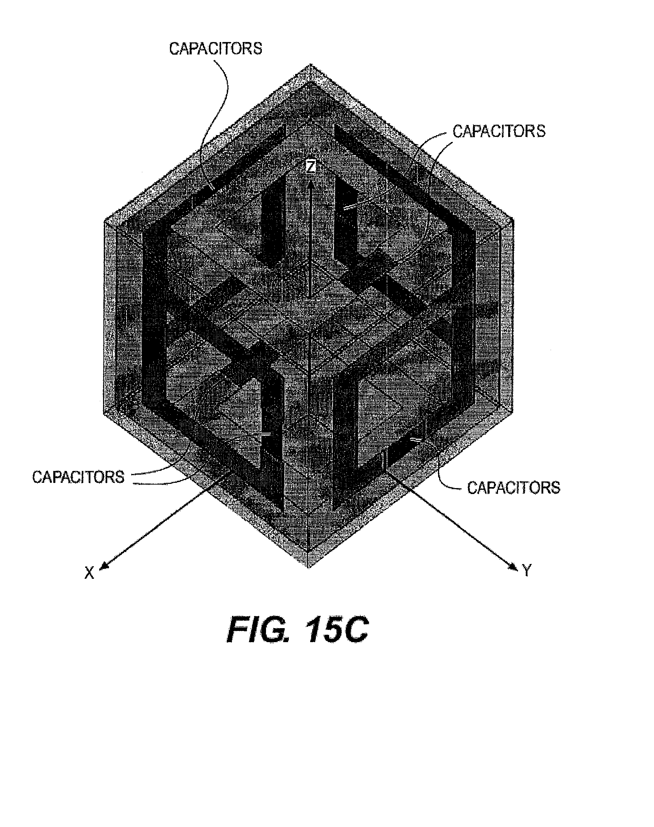

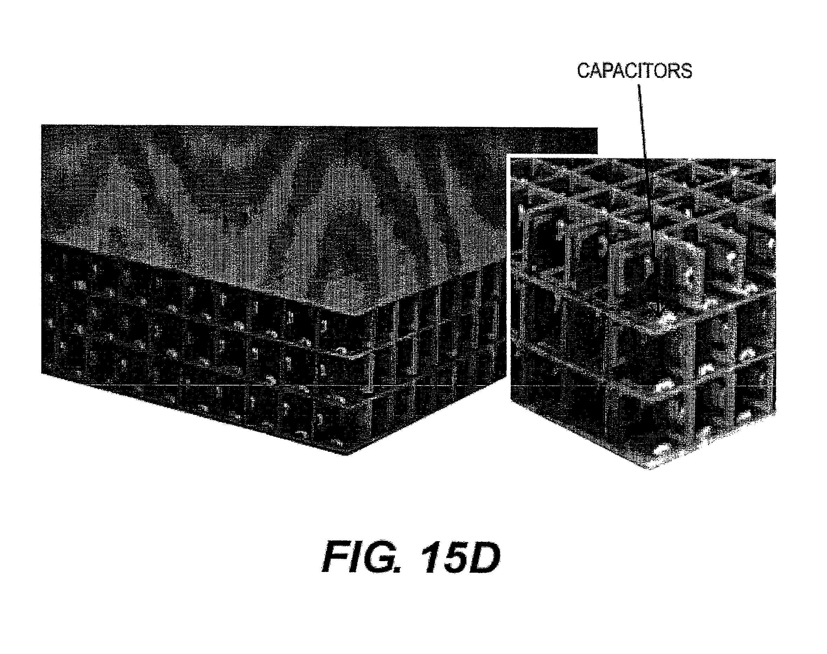

FIGS. 15A, 15B, 15C and 15D illustrate exemplary metamaterial lenses for use in a Direct Magnetic Imager according to an embodiment of the present invention. The metamaterial lenses illustrated in FIGS. 15A-15D include a 3T metamaterial lens (FIG. 15A) which has been experimentally fabricated. In an exemplary embodiment, the 3T metamaterial lens may be used in an MRI imager.

The metamaterial lens illustrated in FIG. 15A includes multiple unit cells shown in FIG. 15B. Each unit cell illustrated in FIG. 15B includes rings with capacitors. FIG. 15C, which illustrates the same unit cell as FIG. 15B, shows the location of the capacitors in the unit cell. FIG. 15D illustrates a partially fabricated metamaterial lens based on the lens shown in FIG. 15A. In exemplary embodiments, the lens is an isotropic lens in which said unit cells are arranged in an array, and each unit cell may include at least one ring with lumped capacitors and/or inductors.

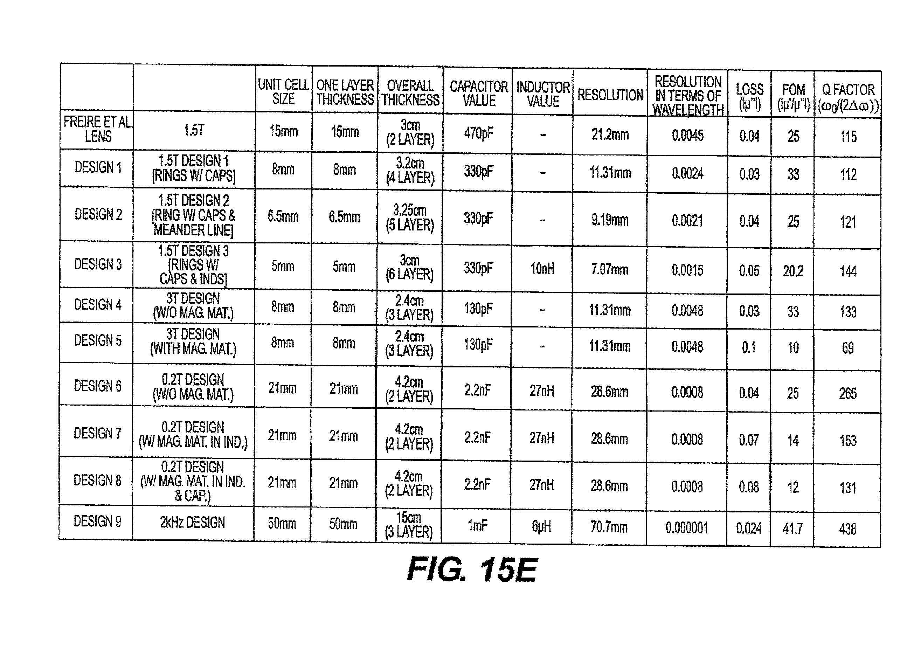

FIG. 15E illustrates details and performance of metamaterial lenses included in a Direct Magnetic Imager according to an embodiment of the present invention. The lens in the first row of the table is disclosed in publication "Experimental Demonstration of a µ= -1 Metamaterials Lens for Magnetic Resonance Imaging", by Freire et al., Applied Physics Letters, 93, 231108, (2008), the entire contents of this publication being hereby incorporated by reference.

Design 1 is for a metamaterial lens which includes rings with capacitors. The lens of Design 2 includes a ring with capacitors ("caps") and meander line inductors. In a meander line antenna, the wire is continuously folded to reduce the resonant length. Increasing the total wire length in an antenna of fixed axial length lowers its resonant frequency. The lens of Design 3 lens includes split rings with lumped capacitors and inductors. An SRR (split ring resonator) element is an electromagnetic analog of an LC circuit, in which the ring acts as an inductor and the gap as a capacitor. As a gap is brought into the ring to build a split ring configuration, the ring geometry becomes an open boundary instead of a closed one. The lenses of the other designs shown in the other rows of the table are 3T designs with or without magnetic materials (Designs 5 and 4), 0.2T designs without magnetic materials (Design 6), with magnetic materials in inductors (Design 7), and with magnetic materials in inductors and capacitors (Design 8), and a 2kHz lens design (Design 9). In an exemplary lens embodiment, one split ring is a split ring resonator element including a metal strip and a gap, wherein the split ring acts as the unit cell and the gap is filled with a capacitor or inductor. The last column in the table illustrates figures of merit (FOM) for lens performance.

The lenses of the various designs have different resonant structure forms, and differ from the lens of Freire et al. in their arrangement of elements (capacitors and/or inductors) on the individual unit cells. The arrangement of elements in the unit cells determines the design for a lens and the form of its resonant structure.

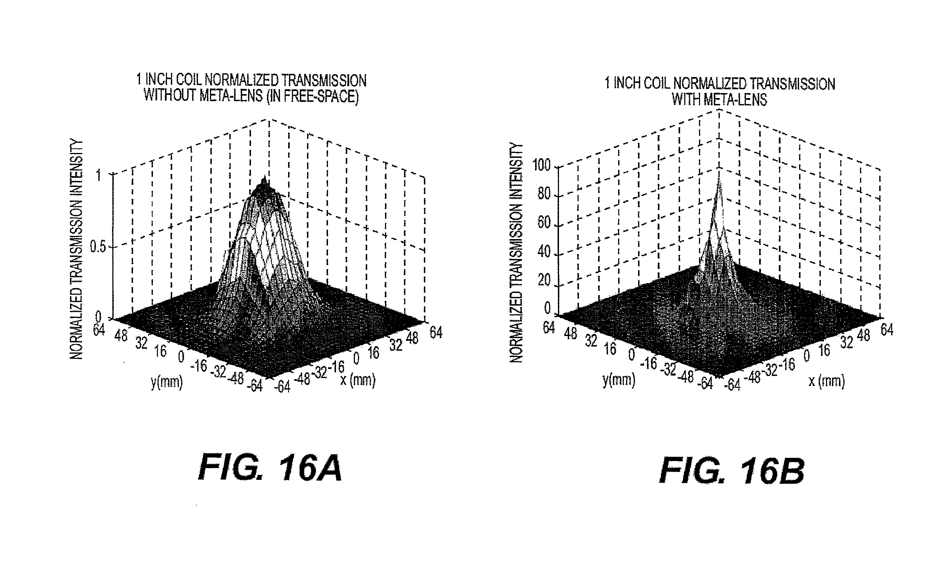

FIGS. 16A and 16B illustrate exemplary measured transmission of a coil without (FIG. 16A) and with (FIG. 16B) the fabricated metamaterial lens shown in FIG. 15A, which can be used in the Direct Magnetic Imager of the present invention. As can be seen in FIG. 16B, the addition of the metamaterial lens achieves a 100X signal improvement. FIGS. 16A and 16B were obtained by measurements performed at ~132MHz frequency where highest Q-value (-100 enhancement) is observed with a focusing spot of ~1.2cm.

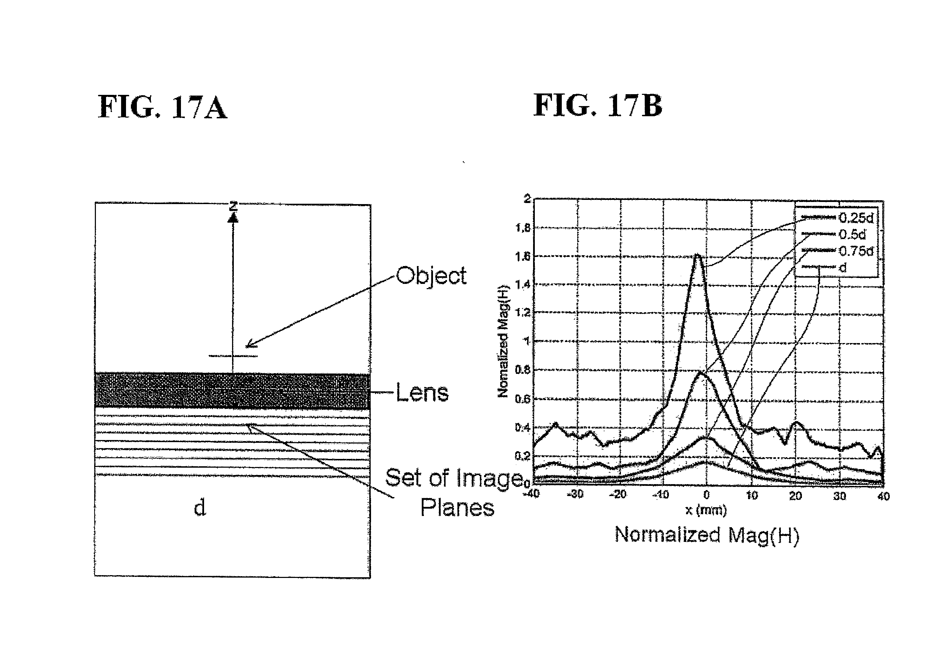

FIGS. 17A and 17B illustrate the change in normalized magnetic field intensity with a change in distance from an object to be imaged with a metamaterial lens used in an exemplary Direct Magnetic Imager according to an embodiment of the present invention. The physical setup for the measurements is shown in FIG. 17A for various image planes. The dimension "d" is the thickness of the metamaterial lens. The lens thickness can be engineered depending on the application, and the lens may include multiple layers.

The Direct Magnetic Imager of the present invention may be arranged in an array such as a hemisphere array or a portable sensor array such as a vest, to obtain detailed spatial information from multiple locations of a subject/object which are within relevant sensing distance from the sensors in sensor array of the Imager. Other form factors that may be used for the arrangement and shape of the Imager include a helmet for traumatic brain injury (TBI) assessment, line arrays for airport security, etc.

The Direct Magnetic Imaging device of the present invention has multiple advantages over state-of-the art imagers. The Imager provides tunability of the input magnetic field with reduced need for power, and is a broader band device. The Imager also exhibits selectivity of the detector to specific frequencies across a broad band without loss of sensitivity. The metamaterials lens acts as a resonant device having a relatively narrow bandwidth, which can therefore act as a filter as well as a concentrator. Metamaterials lenses in the Imager can be tuned, and can be used in a broad magnetic field range, from low magnetic fields such as, for example, µT fields or mT fields, to medium and large magnetic fields (e.g., 0.1T range and Tesla range magnetic fields or larger fields).

Due to the lensing effect (both in input field and detected field), enhanced signal gathering from a target may decrease the need for extensive shielding and allow for larger distances to target, for stand off detection. Therefore, an object or target imaged with the Imager of the present invention does not have to be in direct contact with the detector, as it could be located at various distances from detector. In exemplary embodiments, the distances from an object/target to the detector may be on the order of centimeter, meter or larger than 1 meter, and the Imager may be used to process signals transmitted or reflected by the object/target. For example, the Imager may be used in airport security or underwater object detection. An Imager used in airport security may be shaped as an enclosing system, to include, for example, a "tunnel" for luggage to pass through for inspection. An Imager used for underwater detection may be a single sided system which interrogates an underwater object, such as an underwater rock formation, an underwater device/vehicle, etc. The underwater object can be interrogated by the Imager without being surrounded by the Imager or located in its proximity. The underwater object may be interrogated by an electric, magnetic, or electric and magnetic wave/field sent by the source of the Imager, so that a reflected signal is generated from the underwater object and received by the Imager's detector/receiver. The detector/receiver may be located in the vicinity of the source. One or more metamaterial lenses concentrate the signal/field sent to the underwater object by the source and/or concentrate the reflected field/signal from the underwater object before the signal is received by the detector/receiver. This Imager configuration may also be used on land for imaging objects located at a distance, or for imaging objects in other media besides water.

The Imager has the ability to specifically tune by frequency or other imaging parameter, to differentiate between multiple material types, anatomical tissue types, substances, etc. at various location inside or on a surface of an object/target. For example, the Imager may be tuned by turning on or off different layers of the metamaterial lens.

For example, in a metamaterial lens which includes multiple unit cells of one type (i.e., cells with magnetic permeability *mu* = -1, or cells with electric permittivity *epsilon =* -1, or cells with refractive index *n* = -1), the focusing depth of the lens may be changed by turning on or off various cell layers via mechanical or electrical switching of the meta-lens array.

In a metamaterial lens which includes layers of different types, such as one layer with magnetic permeability *mu* = -1 and another layer with refractive index n = -1, the magnetic permeability *mu* = -1 layer or the refractive index *n* = -1 layer may be turned on or off to change the type of field enhancement of the lens (i.e., magnetic focusing versus magnetic and electric field focusing). In a metamaterial lens which includes layer(s) with magnetic permeability *mu* = -1, and/or layer(s) with electric permittivity *epsilon =* -1, and/or layer(s) with refractive index n = -1, different types of layers may be selectively turned on or off to provide magnetic and/or electric and/or magnetic and electric field focusing. Layers with magnetic permeability *mu* = -1 and/or layer(s) with electric permittivity *epsilon* = -1 and/or layer(s) with refractive index n = -1 included in one metamaterial lens may also be used simultaneously, to provide multiple types of field enhancement for the lens, at the same time.

Simulations and preliminary testing of individual components of the Direct Magnetic Imager have been performed. These include simulations, fabrication, and measurement of the metamaterial lens and characterization of a single magnetometer sensor.

The Direct Magnetic Imager of the present invention has the ability to perform imaging portably and on the field, and can therefore be used in any location, for clinical and emergency response and diagnostics, in the field military and surveillance applications, mobile security analysis, etc. The imager of the present invention can be used in various locations, in various climates, and may be designed to be easily carried to any field location, for example by a person physically transporting the imager carrying it in a cart, to perform immediate imaging without compromising detection quality. The Direct Magnetic Imager may be integrated into a compact form factor, to perform imaging portably in any setting. The form factor with which the device may be integrated may be, for example, a helmet-like form factor, or a portable unit for security imaging. When the device is integrated in a helmet-like form factor, the source, metamaterial lenses and detector are included in the helmet, to detect localized damage in the head of a subject.

Principles of the present invention are applicable to various types of anatomical detection, as well as non-anatomical detection and imaging. Applications for the Direct Magnetic Imager of the present invention include underwater magnetic sensing and vehicle detection, imaging for weapons, airport security, imaging for metal containers, magnetic imaging for border patrol, and advanced sensors. While some aspects of the Direct Magnetic Imager have been described in the context of MRI or NMR detection, the principles of the current invention apply equally to direct detection of other features through magnetic or electric imaging techniques that detect signatures/characteristics of substances/materials based on changes in an electromagnetic field.

Furthermore, although detailed embodiments and implementations of the present invention have been described above, it should be apparent that various modifications are possible without departing from the spirit and scope of the present invention.

## Claims

1. An imager, said imager comprising:
a field source capable of generating an electromagnetic field directed to an area in an object or target;
a field detector arranged downstream from said field source, said field detector being capable of detecting a field signature associated with said area in said object or target; and
a metamaterial lens structure arranged downstream from said field source, said metamaterial lens structure concentrating said field signature from said area in said object or target to said field detector.

2. The imager according to claim 1, wherein
said metamaterial lens structure includes one or more metamaterial lenses,
each of said metamaterial lenses includes multiple unit cells, each unit cell including at least one ring with at least one of lumped capacitors and lumped inductors, and
for each metamaterial lens the magnetic permeability is equal to minus one, or the electric permittivity is equal to minus one, or the refractive index is equal to minus one.

3. The imager according to any preceding claim, where the metamaterial lens structure concentrates the field signature by concentrating the electromagnetic field produced by said field source to said area in said object or target.

4. The imager according to any preceding claim, wherein said metamaterial lens structure is configured such that it can be refocused in one or more dimensions.

5. The imager according to any preceding claim, wherein said metamaterial lens structure enables the imager to perform direct magnetic imaging by focusing a magnetic field into the object or target or into the field detector.

6. The imager according any preceding claim, wherein said electromagnetic field includes an RF signal, and said metamaterial lens structure performs focusing of said RF signal by encoding said RF signal in multiple spatial dimensions.

7. The imager according to any preceding claim, wherein said electromagnetic field is an AC magnetic field at a frequency characteristic to said object/target, and said metamaterial lens structure focuses said AC magnetic field into said object/target and also focuses said field signature to said field detector.

8. The imager according to any preceding claim, wherein said metamaterial lens structure concentrates said field signature from said area in said object/target to said field detector, and said metamaterial lens is tuned to specific frequencies in conjunction with frequencies detected by said field detector.

9. An imaging method, said method comprising:
generating an electromagnetic field directed to an area in an object or target;
detecting a field signature associated with said area in said object or target; and
concentrating, using a metamaterial lens structure, said field signature from said area in said object or target before said detecting step.

10. The method according to claim 9, the method further comprising:
providing a metamaterial lens structure having multiple unit cells; and
providing each unit cell with at least one ring including at least one of lumped capacitors and lumped inductors.

11. The method according to any preceding claim, said concentrating the field signature including concentrating the electromagnetic field produced by said field source to said area in said object or target.

12. The method according to any preceding claim, said concentrating step comprising refocusing said metamaterial lens structure in one or more dimensions.

13. The method according to any preceding claim, the method further comprising performing direct magnetic imaging by focusing a magnetic field into the object or target or into the field detector with said metamaterial lens structure.

14. The method according to any preceding claim, wherein
said electromagnetic field is an AC magnetic field at a frequency characteristic to said object/target, and
said concentrating step includes
focusing said AC magnetic field into said object/target, and
focusing said field signature from said object/target before said detecting.

15. The method according to claim 14, said providing a metamaterial lens structure including providing a first metamaterial lens structure and a second metamaterial lens structure;
said focusing said AC magnetic field being performed with the first metamaterial lens structure; and
said focusing said field signature being performed with the second metamaterial lens structure.

16. The method according to any of claims 1 - 14, said providing a metamaterial lens structure including providing a first metamaterial lens structure and a second metamaterial lens structure; and
said concentrating step including
concentrating an RF field by the first metamaterial lens structure to an anatomical area, and
concentrating a magnetic field signature from said anatomical area to an RF receiver by the second metamaterial lens structure.

17. The method according to any preceding claim, wherein said concentrating step is performed by one or more metamaterial lenses with a refractive index equal to minus one, or with a magnetic permeability equal to minus one, or with an electric permittivity equal to minus one.

18. A metamaterial lens, said lens comprising:
multiple unit cells, each unit cell including at least one ring with at least one of lumped capacitors and lumped inductors.

19. The metamaterial lens according to any preceding claim, wherein said lens is an isotropic lens in which said unit cells are arranged in an array.

20. The metamaterial lens according to any preceding claim, wherein each of said unit cells includes at least one split ring with lumped capacitors and inductors.

21. The metamaterial lens according to claim 20, wherein said at least one split ring is a split ring resonator element including a metal strip and a gap, wherein said split ring acts as the unit cell and said gap is filled with a capacitor or inductor.

22. The metamaterial lens according to any preceding claim, wherein said lens includes a magnetic material in inductors in said unit cells.

23. The metamaterial lens according to any preceding claim, wherein each of said unit cells is a parallelepiped including said capacitors and inductors along a plurality of sides of said parallelepiped.
